# EUROPEAN PATENT APPLICATION

(11) **EP 4 676 192 A2**
(43) Date of publication of application: **07.01.2026**
(21) Application number: 25216802.6
(22) Date of filing: 18.11.2025
(51) Int. Cl.: H10F 77/20, H10F 19/90

(54) **BACK CONTACT CELL AND PHOTOVOLTAIC MODULE**

(30) Priority: 10.03.2025 CN 202510279667
(71) Applicant: Zhejiang Jinko Solar Co., Ltd., Haining, Zhejiang 314416 (CN)
(72) Inventor: ZHANG, Chenming, Haining, Zhejiang, 314416 (CN); XIA, Zhipeng, Haining, Zhejiang, 314416 (CN); LU, Sitian, Haining, Zhejiang, 314416 (CN); HUANG, Jide, Haining, Zhejiang, 314416 (CN); LIU, Changming, Haining, Zhejiang, 314416 (CN); ZHANG, Xinyu, Haining, Zhejiang, 314416 (CN); JIN, Hao, Haining, Zhejiang, 314416 (CN)
(74) Representative: Ipsilon

(57) **Abstract**

The present disclosure provides a back contact cell and a photovoltaic module. The back contact cell includes: a cell substrate; first and second busbars alternately arranged on the cell substrate in a first direction, the first busbar including a plurality of first sections spaced apart in a second direction, and the second busbar including a plurality of second sections spaced apart in the second direction; a first through-wire extending in the first direction and in contact connection with a plurality of first sections in a same row in the first direction; and a second through-wire extending in the first direction and in contact connection with a plurality of second sections in a same row in the first direction. The adjacent first through-wire and the second through-wire form a through-wire set. The number of the through-wire set is designed to decrease as the number of busbars increases.

## Description

### TECHNICAL FIELD

The present disclosure relates to the photovoltaic field, and in particular to a back contact cell and a photovoltaic module.

### BACKGROUND

Interdigitated back contact (IBC) cells are a type of back-junction, back-contact photovoltaic cell, with positive and negative electrodes arranged in an interdigitated pattern on the back side of the photovoltaic cell, while the light-receiving side of the cell remains unobstructed by metal electrodes, thereby effectively increasing the short-circuit current of the photovoltaic cell. A plurality of photovoltaic cells are electrically connected through solder ribbons to form a photovoltaic module. The currents generated within the photovoltaic cells are first collected by fingers, then by busbars that are electrically connected to the fingers, and subsequently by the solder ribbons that are electrically connected to the busbars.

However, since different busbars are electrically connected to different solder ribbons, and these solder ribbons are spaced apart from each other, the collection paths for the currents generated within the IBC cells through the solder ribbons are limited. The currents can only be collected separately from the various busbars. If the fingers and/or the busbars in a specific region of the IBC cell malfunction and fail to effectively collect the currents, significant differences in current levels may arise between that region and other regions of the IBC cell. This localized malfunction makes the affected region prone to the hot spot effect, thereby reducing the photoelectric conversion efficiency of the IBC cell.

Therefore, there is a need for further improvement in the electrical performance of back contact cells.

### SUMMARY

Embodiments of the present disclosure provide a back contact cell and a photovoltaic module, which are at least beneficial for enhancing the electrical performance of the back contact cell and reducing the preparation cost of the back contact cell.

In an aspect of the present disclosure, a back contact cell is provided, which includes: a cell substrate; a first busbar and a second busbar alternately arranged on the cell substrate in a first direction, the first busbar including a plurality of first sections spaced apart in a second direction, and the second busbar including a plurality of second sections spaced apart in the second direction; a first through-wire extending in the first direction and in contact connection with a plurality of first sections in a same row in the first direction; and a second through-wire extending in the first direction and in contact connection with a plurality of second sections in a same row in the first direction. The first through-wire and the second through-wire adjacent to each other form a through-wire set. The number of the through-wire set is designed to decrease as the number of busbars increases; and wherein in the second direction, a width of one or both of the first through-wire and the second through-wire is designed to decrease as the number of the busbars increases. The number of the busbars is a sum of the number of the first busbar and the number of the second busbar.

In some embodiments, the number of the busbars is less than a first threshold, and the number of the through-wire set is greater than a first preset value; alternatively, the number of the busbars is greater than or equal to the first threshold, and the number of the through-wire set is less than a second preset value, wherein the first preset value is greater than the second preset value.

In some embodiments, the back contact cell further includes: a plurality of first fingers and a plurality of second fingers located on the cell substrate and alternately arranged in the second direction. The second fingers are disconnected at the first busbar. The first fingers are disconnected at the second busbar. Disconnections of the second fingers are configured to allow the first busbar to make contact connection with the plurality of first fingers arranged in the second direction. Disconnections of the first fingers are configured to allow the second busbar to make contact connection with the plurality of second fingers arranged in the second direction. The number of the busbars is less than the first threshold, and a ratio of a width of one or more of the first through-wire and the second through-wire in the second direction to a width of fingers in the second direction is within a first preset range; alternatively, the number of the busbars is greater than or equal to the first threshold, and a ratio of the width of one or more of the first through-wire and the second through-wire in the second direction to the width of the fingers in the second direction is within a second preset range, wherein a minimum value within the first preset range is greater than a minimum value within the second preset range, a maximum value within the first preset range is greater than a maximum value within the second preset range, and the fingers include the first fingers and the second fingers.

In some embodiments, the back contact cell includes a cell piece, the whole cell piece is divided into N portions to obtain N cell substrates, where N is a positive integer greater than 1. The cell substrate includes a first border region, a central region, and a second border region arranged sequentially in the second direction. At least part of the N cell substrates has the first border region located at an edge of the whole cell piece. The back contact cell further includes: a third through-wire located on the first border region and extending in the first direction, and a fourth through-wire located on the second border region and extending in the first direction. One of a plurality of first sections and a plurality of second sections located on the first border region and in a same row in the first direction is in contact connection with the third through-wire, while the other is in contact connection with the first through-wire or the second through-wire. One of a plurality of first sections and a plurality of second sections located on the second border region and in a same row in the first direction is in contact connection with the fourth through-wire, while the other is in contact connection with the first through-wire or the second through-wire. In the second direction, a spacing between the third through-wire and the nearest through-wire set is defined as a first spacing, a spacing between adjacent through-wire sets is defined as a second spacing, and the first spacing is smaller than the second spacing.

In some embodiments, on at least part of the cell substrate, in a direction pointing from the first border region to the central region, the spacing between different adjacent through-wire sets is gradually increased.

In some embodiments, among three adjacent through-wire sets in the second direction, a ratio of a spacing between two adjacent through-wire sets that are farther from the first border region to a spacing between two adjacent through-wire sets that are closer to the first border region ranges from 1 to 2.

In some embodiments, a spacing between the fourth through-wire and the nearest through-wire set is defined as a third spacing, and on at least part of the cell substrate, the third spacing is greater than the second spacing.

In some embodiments, the back contact cell further includes: a plurality of first solder pads, each first section being in contact connection with at least one first solder pad; and a plurality of second solder pads, each second section being in contact connection with at least one second solder pad. On at least part of the cell substrate, in a direction pointing from the first border region to the central region, the number of the first solder pad located between different adjacent through-wire sets is gradually increased, and/or the number of the second solder pad located between different adjacent through-wire sets is gradually increased.

In some embodiments, the cell substrate comprises a base and a passivation layer located on a surface of the base, and both the first through-wire and the second through-wire are partially embedded into the passivation layer.

In another aspect of the present disclosure, a photovoltaic module is further provided, including: a cell string formed by connecting a plurality of back contact cells according to any one of the embodiments as described above; an encapsulating film covering the cell string; and a cover plate located on a side of the encapsulating film away from the cell string.

The technical solutions provided in the embodiments of the present disclosure have at least the following advantages:

Given that the overall layout area on the back contact cell remains unchanged, when a larger number of busbars are provided, there is a smaller impact on the entire back contact cell when at least a partial region of a certain first busbar or a certain second busbar malfunctions, therefore, designing a smaller number of through-wire sets can produce a good current equalization effect on the entire back contact cell, which is sufficient to improve the electrical performance and the hot-spot resistance of the back contact cell. On the contrary, when a smaller number of busbars are provided, there is a larger impact on the entire back contact cell when at least a partial region of a certain first busbar or a certain second busbar malfunctions, therefore, designing a larger number of through-wire sets is required to reduce the impact of the malfunction on the entire back contact cell to ensure the good current equalization effect on the entire back contact cell and ensure the good hot-spot resistance of the back contact cell. Therefore, based on the design of the through-wire sets, designing the number of the through-wire sets to decrease as the number of the busbars increases is conducive to reducing the probability of the hot-spot effect occurring in the back contact cell by the through-wire sets, while reducing the costs associated with preparing the first busbars, the second busbars, and the through-wire sets.

### BRIEF DESCRIPTION OF THE DRAWINGS

FIG. 1 is a first schematic partial top view of a back contact cell according to an embodiment of the present disclosure;
FIG. 2 is a second schematic partial top view of a back contact cell according to an embodiment of the present disclosure;
FIG. 3 is a schematic partial top view of a single first busbar in a back contact cell according to an embodiment of the present disclosure;
FIG. 4 is a schematic partial top view of a single second busbar in a back contact cell according to an embodiment of the present disclosure;
FIG. 5 is a third schematic partial top view of a back contact cell according to an embodiment of the present disclosure;
FIG. 6 is a partial cross-sectional schematic view of the back contact cell shown in FIG. 1 in a first cross-sectional direction AA1;
FIG. 7 is a partial perspective schematic view of a photovoltaic module according to another embodiment of the present disclosure; and
FIG. 8 is a partial cross-sectional schematic view taken in a second cross-section direction BB1 in FIG. 7.

### DETAILED DESCRIPTION

From the background art, it is evident that there is a need for improvement in the electrical performance of back contact cells.

The inventors have found through analysis that in existing IBC cells, currents on different busbars of the same polarity, such as those on different positive electrode busbars, are collected by different solder ribbons. There is no mutual flow pathway for both the currents collected on different busbars of the same polarity and the currents collected on the respective solder ribbons. When a partial region of the IBC cell, such as a section of a busbar, malfunctions and fails to effectively collect currents, the actual currents collected by that busbar are less than those in an ideal state. This results in significant differences in the actual current on that busbar compared to other busbars of the same polarity, thereby reducing the uniformity of current transmission across the entire cell piece. Consequently, the region of the cell piece that malfunctions generates more heat, leading to the hot spot effect, which in turn reduces the photoelectric conversion efficiency of the IBC cell and the overall uniformity of the photoelectric conversion efficiency across the entire IBC cell.

Embodiments of the present disclosure provide a back contact cell and a photovoltaic module. In the back contact cell, given that the overall layout area on the back contact cell remains unchanged, when a larger number of busbars are provided, if at least a partial region of a certain first busbar or a certain second busbar malfunctions, there would be a reduced impact on the entire back contact cell, therefore, designing a smaller number of through-wire sets can produce a good current equalization effect on the entire back contact cell, which is sufficient to improve the electrical performance and the hot-spot resistance of the back contact cell. On the contrary, when a smaller number of busbars are provided, if at least a partial region of a certain first busbar or a certain second busbar malfunctions, there would be an increased impact on the entire back contact cell, therefore, designing a larger number of through-wire sets is required to reduce the impact of the malfunction on the entire back contact cell to ensure the good current equalization effect on the entire back contact cell and ensure the good hot-spot resistance of the back contact cell. Thus, based on the design of the through-wire sets, reducing the number of the through-wire sets as the number of the busbars increases is conducive to decreasing the probability of the hot-spot effect occurring in the back contact cell due to the through-wire sets and improving the electrical performance of the back contact cell, while reducing the costs associated with preparing the first busbars, the second busbars, and the through-wire sets.

In the description of the embodiments of the present disclosure, the technical terms such as "first" and "second" are used only to distinguish different objects, but not to be understood as indicating or implying relative importance or implicitly specifying the number, particular order, or primary and secondary relationship of the indicated technical features. In the description of the embodiments of the present disclosure, "a plurality of" means two or more, unless otherwise expressly and specifically defined.

A reference to "embodiment" herein means that a particular feature, structure, or characteristic described in conjunction with the embodiment may be included in at least one embodiment of the present disclosure. In various locations of the specification, the appearance of this phrase does not necessarily refer to the same embodiment, nor is it an independent or alternative embodiment mutually exclusive with other embodiments. Those skilled in the art explicitly and implicitly understand that the embodiments described herein may be combined with other embodiments.

In the description of the embodiments of the present disclosure, the term "and/or" is only an association relationship for describing associated objects, indicating that there may be three relationships. For example, A and/or B may represent three situations: A exists alone, both A and B exist, and B exists alone. In addition, the character "/" herein generally indicates an "or" relationship between the preceding and succeeding associated objects.

In the description of the embodiments of the present disclosure, the term "a plurality of" refers to two or more (including two). Similarly, "a plurality of groups" refers to two or more (including two) groups, and "a plurality of pieces " refers to two or more (including two) pieces.

In the description of the embodiments of the present disclosure, the orientation or position relationship indicated by the technical terms "center", "longitudinal", "transverse", "length", "width", "thickness", "upper", "lower", "front", "back", "left", "right", "vertical", "horizontal", "top", "bottom", "inner", "outer", "clockwise", "anticlockwise", "axial direction", "radial direction", "circumferential direction", and the like are based on the orientation or position relationship shown in the accompanying drawings and are intended to facilitate the description of the embodiments of the present disclosure and simplify the description only, rather than indicate or imply that an apparatus or element referred to must have a particular orientation or be constructed and operated in a particular orientation, and therefore are not to be understood as limitations on the embodiments of the present disclosure.

In the description of the embodiments of the present disclosure, unless otherwise expressly specified and limited, the technical terms "mount", "link", "connect", "fix", and the like should be understood in a broad sense, such as, a fixed connection, a detachable connection, or an integrated connection; a mechanical connection, or an electrical connection; and a direct connection, an indirect connection through an intermediate medium, an internal communication of two elements, or interaction between two elements. Those of ordinary skill in the art may understand the specific meanings of the above-mentioned terms in the embodiments of the present disclosure according to specific situations.

In the accompanying drawings corresponding to the embodiments of the present disclosure, thicknesses and areas of layers are enlarged for a better understanding and ease of description. When one component (e.g., a layer, a film, a region, or a base) is described as being on another component, the component may be "directly" located on the surface of the other component, or a third component may exist between the two components. On the contrary, when one component is described as being on a surface of another component, or one component is described as being formed or provided with another component, it indicates that no third component exists between these two components. Additionally, when one component is described as being formed "generally" on another component, it means that the component is not formed on an entire surface (or a front surface) of the another component, nor is it formed on a portion of an edge of the entire surface.

In the description of the embodiments of the present disclosure, when a certain component "includes" another component, unless otherwise specified, the presence of other components is not excluded, and other components may further be included. Additionally, when a component such as a layer, a film, a region, or a plate is referred to as being "on/located on" another component, the component may be "directly on" the another component (i.e., located on a surface of the another component with no other components in between), or there may be yet another component intervening between these two components. Additionally, when a component such as a layer, a film, a region, or a plate is referred to as being "directly located on" another component, or as being located on a surface of another component, it indicates that no other components are located between these two components.

In the description of the embodiments of the present disclosure, the term "cell substrate" refers to a portion or the entirety of a cell piece that is capable of converting light energy into electrical energy. The cell substrate may include a silicon base and various films/layers provided on the silicon base, such as a passivation layer, an antireflection layer, and an electrode layer.

The terms used in the description of various embodiments herein are only for the purpose of describing specific embodiments and are not intended for limitations. As used in the description of various embodiments and in the appended claims, "the component" is also intended to include a plural form, unless the context clearly indicates otherwise. The component includes a layer, a film, a region, a plate, etc.

The various embodiments of the present disclosure will be described in detail below with reference to the accompanying drawings. However, those of ordinary skill in the art should understand that many technical details are set forth in the embodiments of the present disclosure to facilitate a better understanding of the embodiments of the present disclosure by readers. Nevertheless, the technical solutions claimed for protection in the embodiments of the present disclosure may still be implemented even without these technical details or with various changes and modifications based on the following embodiments.

An embodiment of the present disclosure provides a back contact cell. The back contact cell provided in an embodiment of the present disclosure will be described in detail below with reference to the accompanying drawings.

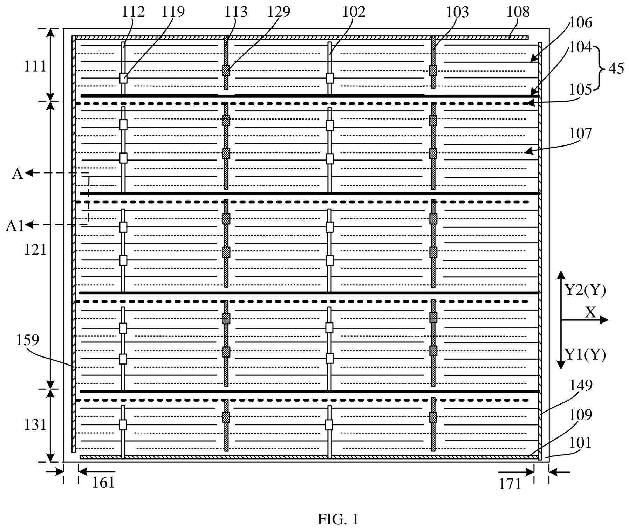

With reference to FIG. 1 to FIG. 4, the back contact cell includes: a cell substrate 101; first busbars 102 and second busbars 103 alternately arranged in a first direction X on the cell substrate 101, where the first busbars 102 each includes a plurality of first sections 112 spaced apart in a second direction Y, and the second busbars 103 each includes a plurality of second sections 113 spaced apart in the second direction Y; a first through-wire 104 extending in the first direction X and in contact connection with a plurality of first sections 112 in a same row in the first direction X; and a second through-wire 105 extending in the first direction X and in contact connection with a plurality of second sections 113 in a same row in the first direction X. The first direction X may be transverse to the second direction Y, for example, orthogonal to the second direction Y.

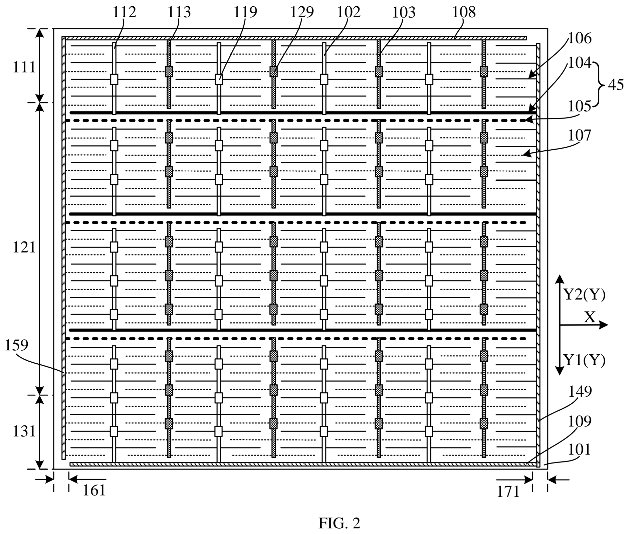

Further, with reference to FIG. 1 and FIG. 2, the first through-wire 104 and the second through-wire 105 adjacent to each other form a through-wire set 45. The number of the through-wire sets 45 is designed to decrease as the number of the busbars increases. Moreover, a width of one or both of the first through-wire 104 and the second through-wire 105 in the second direction Y is designed to decrease as the number of the busbars increases. The number of the busbars is a sum of the number of the first busbars 102 and the number of the second busbars 103.

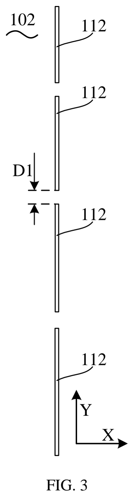

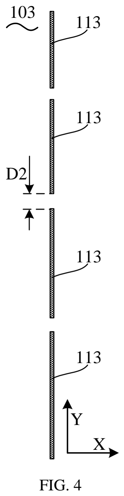

FIG. 1 is a first schematic partial top view of the back contact cell according to an embodiment of the present disclosure; FIG. 2 is a second schematic partial top view of the back contact cell according to an embodiment of the present disclosure; FIG. 3 is a schematic partial top view of a single first busbar in the back contact cell according to an embodiment of the present disclosure; and FIG. 4 is a schematic partial top view of a single second busbar in the back contact cell according to an embodiment of the present disclosure. It should be noted that, to facilitate the distinction between the first busbars 102 and the second busbars 103, different filling methods are used to depict the first busbars 102 and the second busbars 103 in FIG. 1 and FIG. 2.

It is worth emphasizing that, comparatively referring to FIG. 1 and FIG. 2, given that the overall layout area on the back contact cell remains unchanged, when a larger number of busbars are provided, both the current apportioned to each of the first busbars 102 and the current apportioned to each of the second busbars 103 are smaller, leading to a smaller impact on the entire back contact cell when at least a partial region of a certain first busbar 102 or a certain second busbar 103 malfunctions, therefore, designing a smaller number of through-wire sets 45 can produce a good current equalization effect on the entire back contact cell, which is sufficient to improve the electrical performance and the hot-spot resistance of the back contact cell. On the contrary, when a smaller number of busbars are provided, both the current apportioned to each of the first busbars 102 and the current apportioned to each of the second busbars 103 are larger, leading to a larger impact on the entire back contact cell when at least a partial region of a certain first busbar 102 or a certain second busbar 103 malfunctions, therefore, designing a larger number of through-wire sets 45 is required to reduce the impact of the malfunction on the entire back contact cell to ensure the good current equalization effect on the entire back contact cell and ensure the good hot-spot resistance of the back contact cell. Moreover, whether a larger number of the busbars are provided or a larger number of the through-wire sets 45 are provided, the preparation cost of the back contact cell will be increased.

Therefore, based on the design of the through-wire sets 45, designing the number of the through-wire sets 45 to decrease as the number of the busbars increases is conducive to reducing the probability of the hot-spot effect occurring in the back contact cell and enhancing the electrical performance of the back contact cell, while reducing the costs associated with preparing the first busbars 102, the second busbars 103, and the through-wire sets 45, thereby balancing the improvement in the electrical performance of the back contact cell and the reduction in the preparation cost.

The following is a detailed description of how the through-wire sets 45 can produce a good current equalization effect on the entire back contact cell to improve the electrical performance of the back contact cell.

It should be noted that, the first through-wire 104 can be simultaneously electrically connected to a plurality of first sections 112 in a same row in the first direction X, so that the plurality of first sections 112 are electrically connected to each other. As a result, the currents on the plurality of first sections 112 may have various flow paths based on the first through-wire 104. Moreover, the plurality of first sections 112 in the same row in the first direction X respectively belong to different first busbars 102, in other words, different first sections 112 of the plurality of first sections 112 in the same row in the first direction X respectively correspond to sub-components of different first busbars 102. As such, by using the first through-wire 104 simultaneously electrically connected to the plurality of first sections 112 in the same row in the first direction X, the plurality of first busbars 102 spaced apart in the first direction X can be connected to each other, forming denser current transmission paths. Additionally, due to the first through-wire 104, the first sections 112 in the same row in the first direction X are at the same potential, thereby effectively avoiding potential differences among the first sections 112 in the same row in the first direction X.

Additionally, in the same first busbar 102, at least a certain number of different first sections 112 are in contact connection with different first through-wires 104, respectively. When a solder ribbon is used subsequently to connect a plurality of back contact cells, the different first through-wires 104 may be electrically connected to the same solder ribbon, so that the different first through-wires 104 are connected to each other, thereby forming further denser current transmission paths. Additionally, due to the solder ribbon, the different first through-wires 104 are also at the same potential, thereby effectively avoiding potential differences among the different first through-wires 104. Accordingly, even the first busbar 102 is disconnected into the plurality of first sections 112, a plurality of first busbars 102 may be electrically connected as a whole by a plurality of first through-wires 104, thereby allowing the plurality of first busbars 102 to be at the same potential. Based on this, even if a section of the first busbar 102 malfunctions, due to the connection by the first through-wires 104, the currents on the plurality of first busbars 102 may achieve current equilibration again to bring the plurality of first busbars 102 back to the same potential, thereby effectively avoiding the phenomenon of partial region heating due to malfunction.

Likewise, the second through-wire 105 can be simultaneously electrically connected to a plurality of second sections 113 in a same row in the first direction X, so that the plurality of second sections 113 are electrically connected to each other. As a result, the currents on the plurality of second sections 113 may have various flow paths based on the second through-wire 105. Moreover, the plurality of second sections 113 in the same row in the first direction X respectively belong to different second busbars 103, in other words, different second sections 113 of the plurality of second sections 113 in the same row in the first direction X respectively correspond to sub-components of different second busbars 103. As such, by using the second through-wire 105 simultaneously electrically connected to the plurality of second sections 113 in the same row in the first direction X, a plurality of second busbars 103 spaced apart in the first direction X can be connected to each other, forming denser current transmission paths. Additionally, due to the second through-wire 105, the second sections 113 in the same row in the first direction X are at the same potential, thereby effectively avoiding potential differences among the second sections 113 in the same row in the first direction X.

Additionally, in the same second busbar 103, at least a certain number of different second sections 113 are in contact connection with different second through-wires 105, respectively. When a solder ribbon is used subsequently to connect a plurality of back contact cells, the different second through-wires 105 may be electrically connected to the same solder ribbon, so that the different second through-wires 105 are connected to each other, forming further denser current transmission paths. Additionally, due to the solder ribbon, the different second through-wires 105 are also at the same potential, thereby effectively avoiding potential differences among the different second through-wires 105. Accordingly, even the second busbar 103 is disconnected into the plurality of second sections 113, a plurality of second busbars 103 may be electrically connected as a whole by a plurality of second through-wires 105, thereby allowing the plurality of second busbars 103 to be at the same potential. Based on this, even if a section of the second busbar 103 malfunctions, due to the connection by the second through-wires 105, the currents on the plurality of the second busbar 103 may achieve current equilibration again to bring the plurality of the second busbar 103 back to the same potential, thereby effectively avoiding the phenomenon of partial region heating due to malfunction.

Therefore, designing the through-wire set 45 including the first through-wire 104 and the second through-wire 105 adjacent to each other is conducive to both interconnecting the plurality of first busbars 102 into a whole and interconnecting the plurality of second busbars 103 into a whole, while ensuring insulation between the first busbars 102 and the second busbars 103. As such, even if a partial region of the back contact cell malfunctions and cannot effectively collect the current such that the actual collected current in the malfunctioning partial region is smaller than that in an ideal state, based on the function of the through-wire set 45, a uniform current flow may also be achieved again on the plurality of first busbars 102 and the plurality of second busbars 103 respectively, so as to improve the overall electrical performance of the back contact cell, such as an equilibration of current density, thereby enhancing the overall uniformity of the photoelectric conversion efficiency of the back contact cell, avoiding the problem of partial heating caused by excessive current differences in different regions of the back contact cell, and thus improving the hot-spot resistance of the back contact cell.

It should be noted that, the malfunction of the partial region of the back contact cell includes but are not limited to the following cases: in some cases, at least a partial region of at least one first busbar 102 or at least one second busbar 103 malfunctions due to, for example, size variations from printing precision or busbar disconnection; in other cases, a material forming the base in the back contact cell has certain defects itself, such as differences in surface defects in different regions of the base; and in yet other cases, there are significant differences in intensities of light received by different regions of the back contact cell, for example, when some regions of the back contact cell are shaded.

It is to be noted that, referring to FIG. 3, designing the first busbar 102 to include the plurality of first sections 112 spaced apart in the second direction Y may be regarded as disconnecting the first busbar 102 into a plurality of segments in the second direction Y, with each segment serving as one first section 112. Referring to FIG. 4, designing the second busbar 103 to include the plurality of second sections 113 spaced apart in the second direction Y may be regarded as disconnecting the second busbar 103 into a plurality of segments in the second direction Y, with each segment serving as one second section 113. With reference to FIG. 1 to FIG. 4, disconnections in the first busbar 102, namely gaps between adjacent first sections 112 in the second direction Y, are used for the passing through of the second through-wires 105; and disconnections in the second busbar 103, namely gaps between adjacent second sections 113 in the second direction Y, are used for the passing through of the first through-wires 104.

The back contact cell provided in an embodiment of the present disclosure is described in detail below.

In some embodiments, with reference to FIG. 1 to FIG. 4, the number of the busbars is less than a first threshold, and the number of the through-wire sets 45 is greater than a first preset value; or, the number of the busbars is greater than or equal to the first threshold, and the number of the through-wire sets 45 is less than a second preset value; wherein the first preset value is greater than the second preset value. In other words, when designing the number of the busbars and the number of the through-wire sets 45 on the back contact cell, the first threshold is set for the number of the busbars. Compared to the case where the number of the busbars is greater than or equal to the first threshold, when the number of the busbars is designed to be less than the first threshold, the number of the through-wire sets 45 is larger. By using a larger number of through-wire sets 45, the impact of the malfunction of part of the busbars on the current uniformity of the back contact cell piece is reduced, thereby ensuring that the back contact cell has good electrical performance.

It should be noted that, the malfunction of part of the busbars includes but are not limited to the following cases: the phenomenon of the breakage of a certain busbar, namely busbar disconnection; or, significant surface defects present in the substrate directly facing the busbars; or, the region where the busbars are located being shaded, resulting in a substantial decrease in the intensity of light received. The busbars include the first busbars 102 or the second busbars 103. Additionally, both FIG. 1 and FIG. 2 are schematic partial top views of the back contact cell. For the clarity of the illustrations, although a left side and a right side of the cell substrate 101 in the first direction X are shown in FIG. 1 and FIG. 2, not all of the first busbars 102 and all of the second busbars 103 on the cell substrate 101 are illustrated.

In some examples, the first threshold may be 18, 19, 20, 21, etc. The first preset value may be 4, 5, 6, etc. The second preset value may be 2, 3, 4, etc.

In one example, the first threshold may be 20, the first preset value may be 5, and the second preset value may be 3. In other words, when the number of the busbars is less than 20, five through-wire sets 45 are designed; and when the number of the busbars is greater than or equal to 20, three through-wire sets 45 are designed.

In some embodiments, with reference to FIG. 1 to FIG. 4, the back contact cell may further include first fingers 106 and second fingers 107 located on the cell substrate 101 and alternately arranged in the second direction Y. The second fingers 107 are disconnected at the first busbars 102, while the first fingers 106 are disconnected at the second busbars 103. Disconnections of the second fingers 107 are used for the first busbars 102 to make contact connection with the plurality of first fingers 106 in the second direction Y, and disconnections of the first fingers 106 are used for the second busbars 103 to make contact connection with the plurality of second fingers 107 in the second direction Y.

Based on this, the correlated design of the number of the busbars with widths of the first through-wires 104, the second through-wires 105, and the fingers in the second direction Y may be classified into at least the following two cases: in some cases, the number of the busbars is less than the first threshold, and a ratio of the width of one or both of the first through-wires 104 and the second through-wires 105 to the width of the fingers in the second direction Y falls within a first preset range; and in other cases, the number of the busbars is greater than or equal to the first threshold, and the ratio of the width of one or both of the first through-wires 104 and the second through-wires 105 to the width of the fingers in the second direction Y falls within a second preset range.

A minimum value within the first preset range is greater than a minimum value within the second preset range, and a maximum value within the first preset range is greater than a maximum value within the second preset range. The fingers include the first fingers 106 and the second fingers 107.

It should be noted that, for ease of distinguishing between the first fingers 106 and the second fingers 107, both FIG. 1 and FIG. 2 illustrate the first fingers 106 with solid lines and the second fingers 107 with dashed lines.

It should be noted that, when the number of the busbars is less than the first threshold, the ratio of the width of one or both of the first through-wires 104 and the second through-wires 105 to the width of the fingers in the second direction Y is taken as a first ratio. When the number of the busbars is greater than or equal to the first threshold, the ratio of the width of one or both of the first through-wires 104 and the second through-wires 105 to the width of the fingers in the second direction Y is taken as a second ratio. Based on this, the purpose of designing the minimum value within the first preset range to be greater than the minimum value within the second preset range and the maximum value within the first preset range to be greater than the maximum value within the second preset range is to ensure that the first ratio is greater than the second ratio.

In other words, with the width of the fingers serving as a fixed reference value, compared to the case where the number of the busbars is greater than or equal to the first threshold, when the number of the busbars is less than the first threshold, designing the ratio of the width of one or both of the first through-wires 104 and the second through-wires 105 to the width of the fingers in the second direction Y to be larger results in a greater width of the first through-wires 104 and/or the second through-wires 105, which is beneficial for further reducing a transmission resistance of the first through-wires 104 and a contact resistance between the first through-wires 104 and the first sections 112, thereby reducing a transmission resistance of the currents between the first sections 112 and the first through-wires 104, enhancing the capability of individual first sections 112 to collect carriers over a larger region on the cell substrate 101, and reducing current losses caused by the transmission resistance as much as possible; and/or, which is beneficial for further reducing a transmission resistance of the second through-wires 105 and a contact resistance between the second through-wires 105 and the second sections 113, thereby reducing the transmission resistance of the currents between the second sections 113 and the second through-wires 105, improving the capability of individual second sections 113 to collect carriers over a larger region on the cell substrate 101, and reducing current losses caused by the transmission resistance as much as possible.

In some cases, compared to the case where the number of the busbars is greater than or equal to the first threshold, when the number of the busbars is less than the first threshold in the second direction Y, only the ratio of the width of the first through-wires 104 to the width of the fingers in the second direction Y may be designed to be larger. That is, the second through-wires 105 may be designed with the same width regardless of the number of the busbars. In other cases, compared to the case where the number of the busbars is greater than or equal to the first threshold, when the number of the busbars is less than the first threshold in the second direction Y, only the ratio of the width of the second through-wires 105 to the width of the fingers in the second direction Y may be designed to be larger. That is, the first through-wires 104 may be designed with the same width regardless of the number of the busbars. In yet other cases, compared to the case where the number of the busbars is greater than or equal to the first threshold, when the number of the busbars is less than the first threshold in the second direction Y, both the ratio of the width of the first through-wires 104 to the width of the fingers and the ratio of the width of the second through-wires 105 to the width of the fingers in the second direction Y may be designed to be larger.

In some examples, the first threshold may be 18, 19, 20, 21, etc. The first preset range may be from 2 to 20, such as 3, 4, 5, 6, 7, 8, 9, 10, 11, 12, 13, 14, 15, 16, 17, 18, 19, etc. The second preset range may be from 1.5 to 15, such as 2, 2.5, 3, 3.5, 4, 4.5, 5, 5.5, 6, 6.5, 7, 7.5, 8, 8.5, 9, 9.5, 10, 10.5, 11, 11.5, 12, 12.5, 13, 13.5, 14, 14.5, etc.

In some embodiments, referring to FIG. 1, FIG. 2, or FIG. 5, FIG. 5 is a third schematic partial top view of a back contact cell according to an embodiment of the present disclosure. A whole cell piece 100 may be divided into N portions to obtain N cell substrates 101, where N is a positive integer greater than 1. That is, a single cell substrate 101 may be 1/N of the whole cell piece 100. The N cell substrate 101 may include a first border region 111, a central region 121, and a second border region 131 arranged sequentially in the second direction Y. At least part of the N cell substrates 101 has the first border region 111 located at an edge of the whole cell piece 100. For example, the outermost cell substrates 101 of the N cell substrates 101 have the first border regions 111 located at edges of the whole cell piece 100.

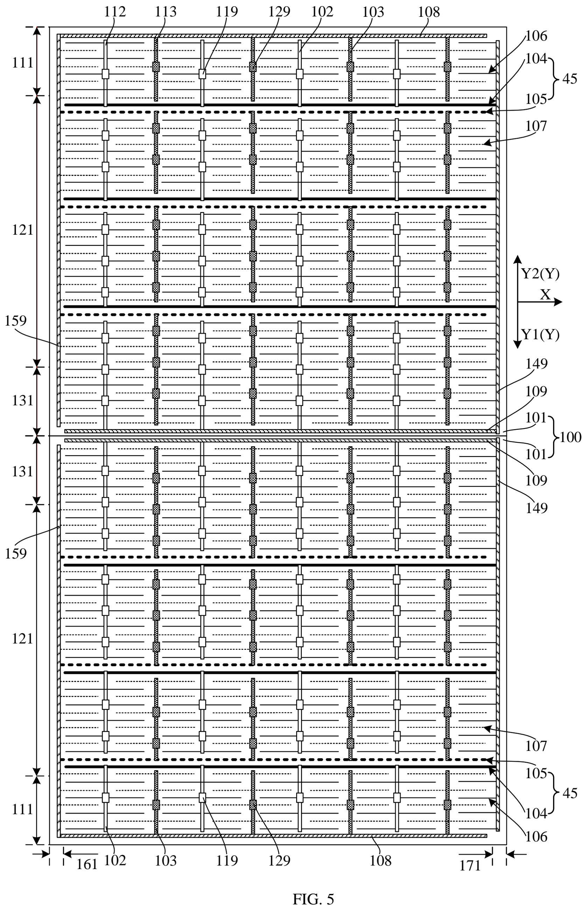

It should be noted that FIG. 1 and FIG. 2 may be regarded as examples where a single back contact cell includes one cell substrate 101, and FIG. 5 may be regarded as an example where a single back contact cell includes two cell substrates 101. Additionally, to facilitate the distinction between the first busbars 102 and the second busbars 103, FIG. 5 also employs different filling methods for the first busbars 102 and the second busbars 103. Moreover, in FIG. 1, FIG. 2, and FIG. 5, the first fingers 106 are illustrated with thinner solid lines, while the second fingers 107 are illustrated with thinner dashed lines. In FIG. 1, FIG. 2, and FIG. 5, the first through-wires 104 are illustrated with thicker solid lines, and the second through-wires 105 are illustrated with thicker dashed lines.

Based on this, continuing to refer to FIG. 1, FIG. 2, or FIG. 5, the back contact cell may further include: a third through-wire 108 located in the first border region 111 and extending in the first direction X; and a fourth through-wire 109 located in the second border region 131 and extending in the first direction X. One of a plurality of first sections 112 and a plurality of second sections 113 located in the first border region 111 and in a same row in the first direction X is in contact connection with the third through-wire 108, while the other is in contact connection with the first through-wire 104 or the second through-wire 105. One of a plurality of first sections 112 and a plurality of second sections 113 located in the second border region 131 and in a same row in the first direction X is in contact connection with the fourth through-wire 109, while the other is in contact connection with the first through-wire 104 or the second through-wire 105. In the second direction Y, a spacing between the third through-wire 108 and the nearest through-wire set 45 is defined as a first spacing, and a spacing between adjacent two through-wire sets 45 is defined as a second spacing, with the first spacing being smaller than the second spacing.

It should be noted that in FIG. 1, FIG. 2, and FIG. 5, as an example, the plurality of second sections 113 located in the first border region 111 and in the same row in the first direction X are in contact connection with the third through-wire 108, while the plurality of first sections 112 located in the first border region 111 and in the same row in the first direction X are in contact connection with the first through-wire 104. In other words, the third through-wire 108 and the first through-wire 104 have different polarities and are respectively arranged at two sides of the plurality of first sections 112 located in the first border region 111 in the second direction Y. In practical applications, based on positional changes of the first through-wire and the second through-wire within the through-wire set, for the plurality of first sections and the plurality of second sections located in the first border region 111 and in the same row in the first direction X, a design may be implemented where the plurality of first sections are in contact connection with the third through-wire, while the plurality of second sections are in contact connection with the second through-wire.

Taking the back contact cell shown in FIG. 2 or FIG. 5 as an example, the following provides a detailed description of designing the first spacing to be smaller than the second spacing. During the process of electrically connecting a plurality of back contact cells into a photovoltaic module using a solder ribbon, a portion of the back contact cell located in the first border region 111 is subjected to a greater stress compared to a portion located in the central region 140, so that the connection strength between the third through-wire 108 and the second sections 113 located in the first border region 111 may be easier to be affected. For example, due to excessive stress on the portion of the back contact cell in the first border region 111, poor contact may occur between the third through-wire 108 and the second sections 113, or the third through-wire 108 may even detach from the second sections 113. In view of this, designing the first spacing to be smaller than the second spacing facilitates a denser arrangement of through-wires in and around the first border region 111, so that even if a partial region of the cell substrate 101 in the first border region 111 malfunctions and fails to effectively collect the currents, the currents generated in this region may also be collected more rapidly by other through-wires due to the denser arrangement of the through-wires, thereby ensuring high efficiency of collecting the currents generated in the cell substrate 101. Moreover, in addition to making contact connection with the busbars and solder pads on the busbars, the solder ribbon may also make further contact connection with the third through-wire 108 and the through-wire sets 45. By utilizing the denser arrangement of the through-wires in and around the first border region 111, a contact area between the solder ribbon and the back contact cell piece may be increased, thereby enhancing the stability of the solder ribbon after welding. The through-wires located in and around the first border region 111 include the third through-wire 108 and the through-wire set 45 closest to the third through-wire 108. The busbars include the first busbars 102 and the second busbars 103.

Additionally, taking the back contact cell shown in FIG. 5 as an example, in the second direction Y, an edge of the third through-wire 108 that is proximate to the nearest through-wire set 45 is defined as a first edge. An edge of the first through-wire 104 in the nearest through-wire set 45 that is proximate to the third through-wire108 is defined as a second edge. The spacing between the third through-wire 108 and the nearest through-wire set 45, namely the first spacing, refers to a distance between the first edge and the second edge in the second direction Y. In the second direction Y, an edge of the second through-wire 105 in one of adjacent two through-wire sets 45 that is proximate to the first through-wire 104 in the other of adjacent two through-wire sets 45 is defined as a third edge. An edge of the first through-wire 104 in other of adjacent two through-wire sets 45 that is proximate to the second through-wire 105 in the one of adjacent two through-wire sets 45 is defined as a fourth edge. A spacing between adjacent two through-wire sets 45, namely the second spacing, refers to a distance between the third edge and the fourth edge in the second direction Y.

Moreover, in FIG. 5, only the case where N is 2, that is, the cell substrate 101 is a half of the cell piece, is taken as an example. In practical applications, a correspondence between the cell substrate 101 and the whole cell piece 100 may be designed according to actual requirements. For example, N may be 3, 4, 5, 6, or the like.

In some cases, referring to FIG. 2 or FIG. 5, on at least part of the cell substrate 101, in a direction Y1 pointing from the first border region 111 to the central region 121, a spacing between different adjacent through-wire sets 45 is gradually increased. It is to be noted that during the process of electrically connecting a plurality of back contact cells into the photovoltaic module using a solder ribbon, the closer a portion of the back contact cell is to the central region 121, the smaller the stress on that portion of the back contact cell, resulting in less impact on the contact connections between the through-wire set 45 and the first sections 112 or the second sections 113 on that portion, which allows for an appropriate increase in the spacing between adjacent through-wire sets 45 while ensuring that the through-wire sets 45 can produce a good current equalization effect on the entire back contact cell, thereby reducing the number of the through-wire sets 45 required to be prepared, and thus lowering the cost of preparation of the through-wire sets 45. It should be noted that the second direction Y includes the direction Y1 pointing from the first border region 111 to the central region 121 and a direction Y2 pointing from the central region 121 to the first border region 111.

In some examples, continuing refer to FIG. 2 or FIG. 5, among three adjacent through-wire sets 45 in the second direction Y, a ratio of a spacing between two adjacent through-wire sets 45 that are farther from the first border region 111 to a spacing between two adjacent through-wire sets 45 that are closer to the first border region 111 ranges from 1 to 2. For example, the ratio may be 1.1, 1.2, 1.3, 1.4, 1.5, 1.6, 1.7, 1.8, 1.9, etc.

The spacing between the two adjacent through-wire sets 45 that are farther from the first border region 111 is defined as a fourth spacing, and the spacing between the two adjacent through-wire sets 45 that are closer to the first border region 111 is defined as a fifth spacing. If the ratio of the fourth spacing to the fifth spacing is greater than 2, then for the two adjacent through-wire sets 45 that are farther from the first border region 111, a length in the second direction Y of the first section 112 in contact connection with the first through-wire 104 in one of the two through-wire sets 45 would be relatively long, and a length in the second direction Y of the second section 113 in contact connection with the second through-wire 105 in the other set is relatively long. In this case, the malfunction of at least a partial region of the first section 112 or the second section 113 would have a significant impact on the entire back contact cell. Therefore, designing the ratio of the fourth spacing to the fifth spacing to be less than or equal to 2 is beneficial for reducing the number of the through-wire sets 45 required be prepared while ensuring that the through-wire sets 45 produce a good current equalization effect on the entire back contact cell.

In some cases, referring to FIG. 2 or FIG. 5, a spacing between the fourth through-wire 109 and the nearest through-wire set 45 is defined as a third spacing. On at least part of the cell substrate 101, the third spacing is greater than the second spacing.

It should be noted that in FIG. 1, FIG. 2, and FIG. 5, as an example, the plurality of first sections 112 located on the second border region 131 and in the same row in the first direction X are in contact connection with the fourth through-wire 109, while the plurality of second sections 113 located on the second border region 131 and in the same row in the first direction X are in contact connection with the second through-wire 105. In other words, the fourth through-wire 109 and the second through-wire 105 have different polarities and are respectively arranged at two sides of the plurality of first sections 112 located on the second border region 131 in the second direction Y. In practical applications, based on positional changes of the first through-wire and the second through-wire in the through-wire set, for the plurality of first sections and the plurality of second sections that are located on the second border region and in the same row in the first direction, a design may be implemented where the plurality of second sections are in contact connection with the fourth through-wire, and the plurality of first sections are in contact connection with the first through-wire.

The following provides a detailed description of designing the third spacing to be greater than the second spacing with the example of the back contact cell shown in FIG. 2 or FIG. 5. During the process of electrically connecting a plurality of back contact cells into the photovoltaic module using a solder ribbon, when the cell substrate 101 is a half of the cell piece, a single solder ribbon is simultaneously electrically connected to two cell substrates 101, with the two cell substrates 101 forming a whole cell piece 100. In this case, the second border regions 131 of the two cell substrates 101 may be located in the middle of the whole cell piece 100. Based on this, a portion of the back contact cell located in the second border region 131 is subjected to a smaller stress than a portion located in the central region 140, leading to a smaller impact of the welding stress on the connection strength between the fourth through-wire 109 and the first sections 112 on the second border region 131border region.

Based on the above, designing the third spacing to be greater than the second spacing facilitates a sparser arrangement of the through-wires in and around the second border region 131, while ensuring that the through-wire sets 45 produce a good current equalization effect on the entire back contact cell, thereby reducing the number of the through-wire sets 45 required be provided on the entire whole cell piece 100, and thus lowering the preparation cost of the through-wire sets 45. The through-wires located in and around the second border region 131 include the fourth through-wire 109 and the through-wire set 45 closest to the fourth through-wire 109.

Additionally, taking the back contact cell shown in FIG. 5 as an example, in the second direction Y, an edge of the fourth through-wire 109 that is proximate to the nearest through-wire set 45 is defined as a fifth edge. An edge of the second through-wire 105 in the nearest through-wire set 45 that is proximate to the fourth through-wire 109 is defined as a sixth edge. The spacing between the fourth through-wire 109 and the nearest through-wire set 45, namely the third spacing, refers to a distance between the fifth edge and the sixth edge in the second direction Y.

In one example, referring to FIG. 5, two cell substrates 101 may be distributed in a similar axial symmetric manner along an adjacent junction of the two cell substrates 101, and busbars and the through-wires on the two cell substrates 101 may also be distributed in the similar axial symmetric manner. The busbars include the first busbars 102, the second busbars 103, the first fingers 106, and the second fingers 107, while the through-wires include the first through-wires 104, the second through-wires 105, the third through-wire 108, and the fourth through-wire 109.

In some cases, referring to FIG. 1 or FIG. 5, the back contact cell may further include: a plurality of first solder pads 119, where each first section 112 is in contact connection with at least one first solder pad 119; and a plurality of second solder pads 129, where each second section 113 is in contact connection with at least one second solder pad 129. On at least part of the cell substrate 101, in the direction pointing from the first border region 111 to the central region 121, the number of the first solder pads 119 located between different adjacent through-wire sets 45 is gradually increased, and/or the number of the second solder pads 129 located between different adjacent through-wire sets 45 is gradually increased.

It is to be noted that, based on the different polarities of the first section 112 and the second section 113, the solder pads, i.e., the first solder pad 119 and the second solder pad 129, also correspond to two polarities. In some examples, in the direction Y1 pointing from the first border region 111 to the central region 121, the spacing between different adjacent through-wire sets 45 is gradually increased. Consequently, the adjacent through-wire sets 45 with a larger spacing may accommodate more first solder pads 119 and second solder pads 129, thereby ensuring that a sufficient number of first solder pads 119 are provided on the first busbars 102 and a sufficient number of second solder pads 129 are provided on the second busbar 103, guaranteeing a sufficiently large contact area between the solder ribbon and the first busbars 102 and the second busbars 103, and thus ensuring the effect of collecting the currents from the first busbars 102 and the second busbars 103 by the solder ribbon.

It should be noted that, in both FIG. 1 and FIG. 5, as an example, between the through-wire sets 45 closest to the first border region 111, two first solder pads 119 are provided on a single first section 112, and two second solder pads 129 are provided on a single second section 113. Additionally, in both FIG. 1 and FIG. 5, as an example, between other through-wire sets 45, three first solder pads 119 are provided on a single first section 112, and three second solder pads 129 are provided on a single second section 113. In practical applications, the number of the first solder pads and the second solder pads between adjacent through-wire sets may be flexibly adjusted according to requirements.

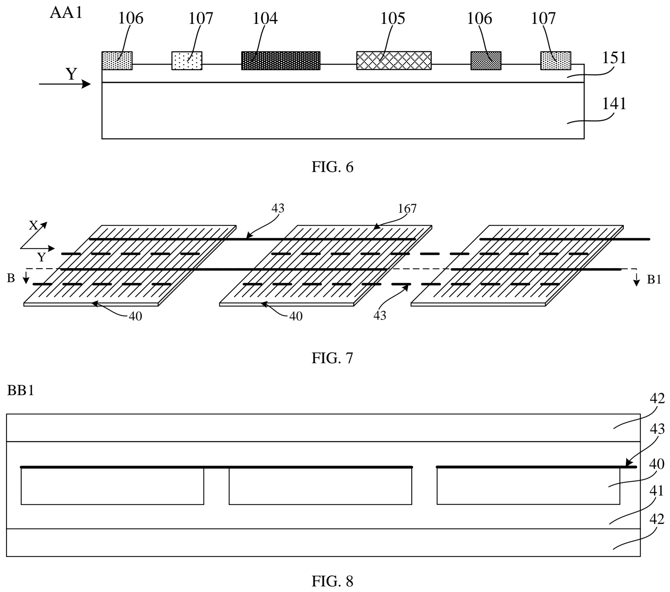

In some embodiments, with reference to FIG. 1 and FIG. 6, FIG. 6 is a partial cross-sectional schematic view of the back contact cell shown in FIG. 1 in a first cross-sectional direction AA1. The cell substrate 101 includes a base 141 and a passivation layer 151 located on a surface of the base 141. Both the first through-wire 104 and the second through-wire 105 are partially embedded into the passivation layer 151.

In this way, the first through-wire 104 not only can be used to electrically connect a plurality of first sections 112 into a whole to achieve uniform current flow within the back contact cell, but also can collect photo-generated carriers generated in the base 141, similar to the fingers, thereby improving the collection efficiency of the photo-generated carriers in the base 141 and enhancing the photoelectric conversion efficiency of the back contact cell. Similarly, the second through-wire 105 not only can be used to electrically connect a plurality of second sections 113 into a whole to achieve uniform current flow within the back contact cell, but also can collect the photo-generated carriers generated in the base 141, similar to the fingers, thereby improving the collection efficiency of the photo-generated carriers in the base 141 and enhancing the photoelectric conversion efficiency of the back contact cell. The fingers include the first fingers 106 and the second fingers 107.

In some cases, materials of both the first through-wire 104 and the second through-wire 105 may be the same as those of the fingers. For example, paste used for preparing the first through-wire 104 and the second through-wire 105 is the same as that used for preparing the fingers. Both the first through-wire 104 and the second through-wire 105, along with the fingers, may be formed by a burn-through paste, so that the first through-wire 104 and the second through-wire 105 can also penetrate through the passivation layer 151. In this way, not only the first through-wire 104 can be used to electrically connect a plurality of first sections 112 into a whole, and the second through-wire 105 can be used to electrically connect a plurality of second sections 113 into a whole, but also both the first through-wire 104 and the second through-wire 105 can independently collect the photo-generated carriers from the base 141, thereby increasing collection paths for the photo-generated carriers and enhancing the photoelectric conversion efficiency of the back contact cell.

In some cases, the passivation layer 151 may be of a single-layer film structure or a stacked film structure. A material of the passivation layer 151 may be selected from a group consisting of silicon oxide, silicon nitride, silicon oxynitride, silicon carbon oxynitride, titanium oxide, hafnium oxide, aluminum oxide, and any combinations thereof.

In some cases, the base 141 has a first surface and a second surface which are opposite to each other. The first surface has a textured structure that can enhance internal reflection of incident light to reduce optical losses and improve the photoelectric conversion efficiency of the back contact cell.

In some examples, the first surface is provided with a front surface field (FSF), where a conductivity type of doped ions is the same as that of the base 141. A surface minority carrier concentration is reduced by using the field passivation effect, thereby lowering the surface recombination rate while decreasing series resistance and enhancing the current transport capability. The first surface is also provided with a first passivation layer and a first anti-reflection layer. The first passivation layer is located on a surface of the front surface field, while the first anti-reflection layer is located on a side of the first passivation layer away from the base 141. It should be noted that, the base 141 does not necessarily include the front surface field, the first passivation layer, or the first antireflection layer.

In some examples, the second surface has a first region and a second region alternately arranged. The first region is one of a P-type region and an N-type region, while the second region is the other of the P-type region and the N-type region. A gap region exists between the P-type region and the N-type region. In other examples, no gap region may exist between the P-type region and the N-type region; and an insulating film layer is provided between the P-type region and the N-type region to achieve insulation between the P-type region and the N-type region and thus insulation between the first fingers 106 and the second fingers 107. The first fingers 106 may be located on one of the first region and the second region, while the second fingers 107 may be located on the other of the first region and the second region.

In some examples, the gap region may be flush with both the P-type region and the N-type region, that is, no etching is performed on the base 141. Insulation between the P-type region and the N-type region is achieved through some isolating film layers. The isolating film layers may be passivation film layers or intrinsic semiconductor layers. In other examples, the gap region may be lower than both the P-type region and the N-type region, so that a channel is provided in the gap region. The channel extends from the second surface toward the first surface. The channel is configured to achieve automatic isolation between regions of different conductivity types, which may eliminate leakage current caused by PN junction formed between heavily doped P-type and N-type regions within the back contact cell, thereby preventing the impact on the cell efficiency.

In some examples, a surface of the gap region may be of a polished surface structure or a textured surface structure.

In some examples, the P-type region and the N-type region may each be provided with a tunneling silicon oxide layer and a doped polysilicon layer, where the P-type region is provided with a P-type doped polysilicon layer, and the N-type region is provided with an N-type doped polysilicon layer. In other examples, the P-type region and the N-type region may each be provided with an intrinsic amorphous silicon layer, a doped amorphous silicon layer, and a transparent conductive layer, with the P-type region being provided with a P-type doped amorphous silicon layer and the N-type region being provided with an N-type doped amorphous silicon layer.

In some examples, a second passivation layer and a second anti-reflection layer are provided on the P-type region, the N-type region, and the gap region. The first fingers 106 and the second fingers 107 are located on the second anti-reflection layer and embedded into the second passivation layer. It should be noted that the second passivation layer is the above-mentioned passivation layer 151.

In other embodiments, materials of both the first through-wire and the second through-wire may also be the same as those of the first busbars. For example, a paste used for preparing the first through-wire and the second through-wire is the same as that used for preparing the first busbars. Both the first through-wire and the second through-wire, along with the first busbars, are formed by a non-burn-through paste. Both the first through-wire and the second through-wire are located on a surface of the passivation layer without embedding into the passivation layer, thereby eliminating the need for layout arrangement of the first region and the second region on the surface of the base beneath the first through-wire and the second through-wire, thus preventing electrical contact between the first through-wire or the second through-wire and the doped region of the opposite polarity, and avoiding the problem of short circuit. Additionally, the first through-wire and the second through-wire may not damage the passivation layer, thereby ensuring the integrity of the film layer of the passivation layer, and thus enhancing the passivation effect of the passivation layer on the base, which is conducive to reducing the optical losses in back contact cell, and improving the photoelectric conversion efficiency of the back contact cell. Additionally, since the non-burn-through paste contains minimal glass powder that may damage PN junctions, metal recombination can be effectively reduced, an open-circuit voltage of the back contact cell can be increased, and the conversion efficiency of the back contact cell can be improved.

It should be noted that the conventional paste may include a mixture of metal powder, glass powder, and an organic carrier. The non-burn-through paste refers to a type of paste that contains less glass powder than the conventional paste, and has a weak burn-through capability and does not require or is unable to burn through the passivation layer during the sintering process. The burn-through paste refers to a type of paste that, during the sintering process, has a strong burn-through capability and is able to burn through the passivation layer.

In practical applications, the first through-wire or the second through-wire may also be a film layer or a conductive wire including a conductive material, provided that the first through-wire can electrically connect a plurality of first sections into a whole, and the second through-wire can electrically connect a plurality of second sections into a whole.

In some embodiments, referring to FIG. 3, in the second direction Y, a spacing D1 between adjacent first sections 112 may range from 10 mm to 12 mm, such as 10.1 mm, 10.2 mm, 10.3 mm, 10.4 mm, 10.5 mm, 10.6 mm, 10.7 mm, 10.8 mm, 10.9 mm, 11 mm, 11.1 mm, 11.2 mm, 11.3 mm, 11.4 mm, 11.5 mm, 11.6 mm, 11.7 mm, 11.8 mm, 11.9 mm, etc., which is beneficial for ensuring appropriate sizes of the disconnections in the first busbars 102, and guaranteeing that as many photo-generated carriers as possible generated within the cell substrate 101 are collected by the first busbars 102, thereby ensuring excellent photoelectric conversion efficiency of the back contact cell.

In some embodiments, referring to FIG. 4, in the second direction Y, a spacing D2 between adjacent second sections 113 may range from 10 mm to 12 mm, such as 10.1 mm, 10.2 mm, 10.3 mm, 10.4 mm, 10.5 mm, 10.6 mm, 10.7 mm, 10.8 mm, 10.9 mm, 11 mm, 11.1 mm, 11.2 mm, 11.3 mm, 11.4 mm, 11.5 mm, 11.6 mm, 11.7 mm, 11.8 mm, 11.9 mm, etc., which is beneficial for ensuring appropriate sizes of the disconnections in the second busbars 103, and guaranteeing that as many photo-generated carriers as possible generated within the cell substrate 101 are collected by the second busbars 103, thereby ensuring excellent photoelectric conversion efficiency of the back contact cell.

In some embodiments, referring to FIG. 1, FIG. 2, or FIG. 5, a whole cell piece 100 is divided into N portions to obtain N cell substrates 101, where N is a positive integer greater than 1. That is, a single cell substrate 101 is 1/N of the whole cell piece 100. The whole cell piece 100 includes a first edge region 161 and a second edge region 171 opposite to each other in the first direction X. The back contact cell may further include: a first edge connection wire 159 located in the first edge region 161 and extending in the second direction Y; and a second edge connection wire 149 located in the second edge region 171 and extending in the second direction Y. The first edge connection wire 159 is in contact connection with one of each first through-wire 104 and each second through-wire 105, while the second edge connection wire 149 is in contact connection with the other of each first through-wire 104 and each second through-wire 105. A width of the edge connection wires in the first direction X is greater than a width of the through-wires in the second direction Y. The edge connection wires include the first edge connection wire 159 and the second edge connection wire 149, while the through-wires include the first through-wire 104 and the second through-wire 105.

It is to be noted that the width of the edge connection wires in the first direction X being greater than the width of the through-wires in the second direction Y means that both the width of the first edge connection wire 159 and the width of the second edge connection wire 149 in the first direction X are greater than both the width of the first through-wire 104 and the width of the second through-wire 105 in the second direction Y.

Moreover, compared to the first through-wire 104 collecting the currents from a plurality of first sections 112 and the second through-wire 105 collecting the currents from a plurality of second sections 113, one of the first edge connection wire 139 and the second edge connection wire 149 aggregates the currents from a plurality of first through-wires 104, while the other aggregates the currents from a plurality of second through-wires 105. Consequently, the amount of the currents aggregated on the first edge connection wire 139 or the second edge connection wire 149 is greater. Based on this, the width of the edge connection wires in the first direction X being greater than the width of the through-wires in the second direction Y results in larger cross-sectional areas and lower transmission resistances for both the first edge connection wire 139 and the second edge connection wire 149, thereby better matching the amount of the currents that need to be aggregated on the first edge connection wire 139 or the second edge connection wire 149, facilitating the improvement on the current transmission efficiency of the first edge connection wire 139 or the second edge connection wire 149, and further enhancing the photoelectric conversion efficiency of the back contact cell.

It should be noted that in FIG. 1, FIG. 2, or FIG. 5, as an example, the first edge connection wire 139 is in contact connection with each second through-wire 105, and the second edge connection wire 149 is in contact connection with each first through-wire 104. In practical applications, based on changes in the numbers of the first busbars 102 and the second busbars 103 provided on the cell substrate 100, the first edge connection wire may alternatively be in contact connection with each first through-wire, and the second edge connection wire may alternatively be in contact connection with each second through-wire.

In some cases, a ratio of the width of the edge connection wires in the first direction X to the width of the through-wires in the second direction Y ranges from 2 to 30, such as 3, 4, 5, 6, 7, 8, 9, 10, 11, 12, 13, 14, 15, 16, 17, 18, 19, 20, 21, 22, 23, 24, 25, 26, 27, 28, 29, etc.

In summary, given that the overall layout area on the back contact cell remains unchanged, when a larger number of busbars are provided, there is a smaller impact on the entire back contact cell when at least a partial region of a certain first busbar 102 or a certain second busbar 103 malfunctions, therefore, designing a smaller number of through-wire sets 45 can produce a good current equalization effect on the entire back contact cell, which is sufficient to improve the electrical performance and the hot-spot resistance of the back contact cell. On the contrary, when a smaller number of busbars are provided, there is a larger impact on the entire back contact cell when at least a partial region of a certain first busbar 102 or a certain second busbar 103 malfunctions, therefore, designing a larger number of through-wire sets 45 is required to reduce the impact of the malfunction on the entire back contact cell to ensure the good current equalization effect on the entire back contact cell and ensure the good hot-spot resistance of the back contact cell. Therefore, based on the design of the through-wire sets 45, designing the number of the through-wire sets 45 to decrease as the number of the busbars increases is conducive to reducing the probability of the hot-spot effect occurring in the back contact cell by the through-wire sets 45, while reducing the costs associated with preparing the first busbars 102, the second busbars 103, and the through-wire sets 45.

Another embodiment of the present disclosure further provides a photovoltaic module. The photovoltaic module includes a plurality of photovoltaic cells (i.e., back contact cells) as provided in the above-mentioned embodiments. The photovoltaic module is configured to convert received light energy into electrical energy. It should be noted that for parts that are identical or corresponding to those in the above-mentioned embodiments, reference may be made to the corresponding descriptions in the above-mentioned embodiments, and no further elaboration will be provided below.

With reference to FIG. 1 to FIG. 6, as well as FIG. 7 and FIG. 8, the photovoltaic module includes: a cell string, the cell string being formed by connecting a plurality of back contact cells 40 as provided in the above-mentioned embodiments; an encapsulating film 41 configured to cover a surface of the cell string; and a cover plate 42 configured to cover a surface of the encapsulating film 41 away from the cell string. The back contact cells 40 are electrically connected in the form of whole pieces or divided pieces to form a plurality of cell strings. The plurality of cell strings are electrically connected in series and/or in parallel.

FIG. 7 is a partial perspective schematic view of a photovoltaic module according to another embodiment of the present disclosure, and FIG. 8 is a partial cross-sectional schematic view taken in a second cross-section direction BB1 in FIG. 7.

In some embodiments, with reference to FIG. 7 and FIG. 8, the plurality of back contact cells 40 may be electrically connected through a solder ribbon 43. FIG. 7 and FIG. 8 merely illustrate one positional relationship between the back contact cells. The back contact cells 40 may also be arranged such that busbars of different polarities face the same side, that is, the busbars of adjacent back contact cells 40 are sequentially arranged in the order of a first polarity, a second polarity, and the first polarity, with the solder ribbon 43 connecting the same side of two adjacent cell pieces 100.

In some embodiments, the encapsulating film 41 includes a first encapsulating layer and a second encapsulating layer. The first encapsulating layer covers one of a front surface or a back surface of the back contact cell 40, while the second encapsulating layer covers the other of the front surface or the back surface of the back contact cell 40. Specifically, one or both of the first encapsulating layer and the second encapsulating layer may be an organic encapsulating film such as a polyvinyl butyral (PVB) film, an ethylene vinyl acetate (EVA) polymer film, a polyolefin elastomer (POE) film, or a polyethylene terephthalate (PET) film. Alternatively, one or both of the first encapsulating layer or the second encapsulating layer may be an EP film, an EPE film, or a PVP film. The EP film refers to a co-extruded film composed of the EVA film and the POE film which are stacked. The EPE film refers to a co-extruded film formed by stacking the EVA film, the POE film, and the EVA film in sequence. The PVP film refers to a co-extruded film formed by stacking the POE film, the EVA film, and the POE film in sequence. A method for preparing a co-extruded film may involve either sequentially extruding one or more raw materials onto prepared another film during the film processing process, or bonding prepared films of different types together.

In some cases, before lamination, there may be a demarcation line between the first encapsulating layer and the second encapsulating layer. However, after lamination processing, the concept of the first encapsulating layer and the second encapsulating layer no longer exists in the photovoltaic module, that is, the first encapsulating layer and the second encapsulating layer are formed the integrated encapsulating film 41.

In some embodiments, the cover plate 42 may be a cover plate with a light-transmitting function, such as a glass cover plate or a plastic cover plate. Specifically, a surface of the cover plate 42 facing the encapsulating film 41 may an uneven surface or a textured surface with a plurality of raised structures, thereby increasing a utilization rate of incident light. The cover plate 42 includes a first cover plate and a second cover plate. The first cover plate faces the first encapsulating layer, and the second cover plate faces the second encapsulating layer.

In some cases, when the back contact cell 40 is a cell with busbars, the surface of the back contact cell 40 is provided with a plurality of busbars spaced apart in the first direction X and a plurality of fingers 167 spaced apart in the second direction Y. Referring to FIG. 1, FIG. 2, or FIG. 5, the busbars include the first busbars 102 and the second busbars 103. During the process of assembling the cell string using the back contact cells 40, the solder ribbon 43 is separately connected to at least one busbar on each of two adjacent back contact cells 40.

## Claims

1. A back contact cell, comprising:
a cell substrate (101);
a first busbar (102) and a second busbar (103) alternately arranged on the cell substrate in a first direction (X), the first busbar comprising a plurality of first sections (112) spaced apart in a second direction (Y), and the second busbar comprising a plurality of second sections (113) spaced apart in the second direction;
a first through-wire (104) extending in the first direction and in contact connection with a plurality of first sections in a same row in the first direction; and
a second through-wire (105) extending in the first direction and in contact connection with a plurality of second sections in a same row in the first direction;
wherein the first through-wire and the second through-wire adjacent to each other form a through-wire set (45), the number of the through-wire set is designed to decrease as the number of busbars increases; and wherein when the number of the busbars is less than 21, the number of the through-wire set is greater than 4, the number of the busbars being a sum of the number of the first busbar and the number of the second busbar.

2. The back contact cell according to claim 1, wherein when the number of the busbars is greater than or equal to 21, the number of the through-wire set is less than or equal to 4;
optionally, when the number of the busbars is less than 18, the number of the through-wire set is greater than 6.

3. The back contact cell according to claim 1 or 2, further comprising:
a plurality of first fingers (106) and a plurality of second fingers (107) located on the cell substrate and alternately arranged in the second direction;
wherein the second fingers are disconnected at the first busbar, the first fingers are disconnected at the second busbar, disconnections of the second fingers are configured to allow the first busbar to make contact connection with the plurality of first fingers arranged in the second direction, and disconnections of the first fingers are configured to allow the second busbar to make contact connection with the plurality of second fingers arranged in the second direction; and
wherein the number of the busbars is 21, and a ratio of a width of one or more of the first through-wire and the second through-wire in the second direction to a width of fingers in the second direction is within a first preset range; alternatively, when the number of the busbars is greater than or equal to 21, and a ratio of the width of one or more of the first through-wire and the second through-wire in the second direction to the width of the fingers in the second direction is within a second preset range, wherein a minimum value within the first preset range is greater than a minimum value within the second preset range, a maximum value within the first preset range is greater than a maximum value within the second preset range, and the fingers comprise the first fingers and the second fingers;
optionally, the first preset range is from 2 to 20, and the second preset range is from 1.5 to 15.

4. The back contact cell according to any one of claims 1 to 3, comprising a cell piece (100), wherein the whole cell piece is divided into N portions to obtain N cell substrates, where N is a positive integer greater than 1;
wherein the cell substrate comprises a first border region (111), a central region (121), and a second border region (131) arranged sequentially in the second direction, and at least part of the N cell substrates has the first border region located at an edge of the whole cell piece;
wherein the back contact cell further comprises: a third through-wire (108) located on the first border region and extending in the first direction, and a fourth through-wire (109) located on the second border region and extending in the first direction;
wherein one of a plurality of first sections and a plurality of second sections located on the first border region and in a same row in the first direction is in contact connection with the third through-wire, while the other is in contact connection with the first through-wire or the second through-wire;
wherein one of a plurality of first sections and a plurality of second sections located on the second border region and in a same row in the first direction is in contact connection with the fourth through-wire, while the other is in contact connection with the first through-wire or the second through-wire; and
wherein in the second direction, a spacing between the third through-wire and the nearest through-wire set is defined as a first spacing, a spacing between adjacent through-wire sets is defined as a second spacing, and the first spacing is smaller than the second spacing.

5. The back contact cell according to claim 4, wherein on at least part of the cell substrate, in a direction pointing from the first border region to the central region, the spacing between different adjacent through-wire sets is gradually increased.

6. The back contact cell according to claim 5, wherein among three adjacent through-wire sets in the second direction, a ratio of a spacing between two adjacent through-wire sets that are farther from the first border region to a spacing between two adjacent through-wire sets that are closer to the first border region ranges from 1 to 2.

7. The back contact cell according to any one of claims 4 to 6, wherein a spacing between the fourth through-wire and the nearest through-wire set is defined as a third spacing, and on at least part of the cell substrate, the third spacing is greater than the second spacing.

8. The back contact cell according to any one of claims 4 to 7, further comprising:
a plurality of first solder pads (119), each first section being in contact connection with at least one first solder pad; and
a plurality of second solder pads (129), each second section being in contact connection with at least one second solder pad;
wherein on at least part of the cell substrate, in a direction pointing from the first border region to the central region, the number of the first solder pad located between different adjacent through-wire sets is gradually increased, and/or the number of the second solder pad located between different adjacent through-wire sets is gradually increased.

9. The back contact cell according to any one of claims 1 to 8, wherein the cell substrate comprises a base (141) and a passivation layer (151) located on a surface of the base, and both the first through-wire and the second through-wire are partially embedded into the passivation layer.

10. The back contact cell according to any one of claims 1 to 9, comprising a cell piece, wherein the whole cell piece is divided into N portions to obtain N cell substrates, where N is a positive integer greater than **1,** and the whole cell piece comprises a first edge region (161) and a second edge region (171) opposite to each other in the first direction;
wherein the back contact cell further comprises: a first edge connection wire (159) located on the first edge region and extending in the second direction, and a second edge connection wire (149) located in the second edge region and extending in the second direction;
wherein the first edge connection wire is in contact connection with one of each first through-wire and each second through-wire, while the second edge connection wire is in contact connection with the other of each first through-wire and each second through-wire; and
wherein a width of edge connection wires in the first direction is greater than a width of through-wires in the second direction, the edge connection wires comprise the first edge connection wire and the second edge connection wire, and the through-wires comprise the first through-wire and the second through-wire;
optionally, a ratio of the width of the edge connection wires in the first direction to the width of the through-wires in the second direction ranges from 2 to 30.

11. The back contact cell according to any one of claims 1 to 11, wherein in the second direction, a spacing between adjacent first sections ranges from 10 mm to 12 mm; and/or, in the second direction, a spacing between adjacent second sections ranges from 10 mm to 12 mm.

12. The back contact cell according to any one of claims 1 to 12, wherein the first direction is transverse to the second direction.

13. The back contact cell according to claim 3, wherein the first through-wire, the second through-wire, the first fingers, and the second fingers are formed from a burn-through paste.

14. The back contact cell according to any one of claims 4 to 8, wherein N is 2, and two second border regions of the two cell substrates are located adjacent to each other in the second direction;
optionally, busbars and through-wires on the two cell substrates are respectively distributed in an axial symmetric manner along an adjacent junction of the two cell substrates, the busbars comprise the first busbar and the second busbar, and the through-wires comprise the first through-wire and the second through-wire.

15. A photovoltaic module, comprising:
a cell string formed by connecting a plurality of back contact cells according to any one of claims 1 to 14;
an encapsulating film covering the cell string; and
a cover plate located on a side of the encapsulating film away from the cell string.
